# EUROPEAN PATENT APPLICATION

(11) **EP 4 670 901 A1**
(43) Date of publication of application: **31.12.2025**
(21) Application number: 24184720.1
(22) Date of filing: 26.06.2024
(51) Int. Cl.: B23K 31/00, B23K 31/12, G06N 3/08, G06N 20/00, H01L 23/00

(54) **A METHOD FOR PREDICTING SHEAR FORCE VALUES IN A WIRE BONDING PROCESS**

(71) Applicant: Robert Bosch GmbH, 70442 Stuttgart (DE)
(72) Inventor: Maszler, Réka, 1149 Budapest (HU); Ludányi, Balázs, 6270 Szeged (HU); Pallagi, Attila, 1191 Budapest (HU); Somodi, Ferenc, 5440 Kunszentmárton (HU)

(57) **Abstract**

The invention relates to a method (100) for predicting shear force values in a wire bonding process, comprising the following steps:
- Providing (101) bonder data, the bonder data comprising values for at least one process parameter that are acquired during the wire bonding process by at least one sensor (2),
- Predicting (102) the shear force values in the wire bonding process based on the provided bonder data using a machine learning model (1).

Furthermore, the invention relates to a computer program, an apparatus, and a storage medium for this purpose.

## Description

The invention relates to a method for predicting shear force values in a wire bonding process. Furthermore, the invention relates to a computer program, an apparatus, and a storage medium for this purpose.

### State of the art

Since their introduction in the 1970's, destructive wire bond pull and shear tests are the exclusive evaluation methods to determine wire bond's strength and quality. During the before-mentioned destructive tests, pull or shear force values that are necessary to break the connection are measured and evaluated.

Nowadays, the biggest disadvantage of the above-mentioned tests is their destructive nature, which increases the analysis cost, and the fact that the reliable measurement of wire pull and shear force can be rather difficult when the distance between the bonded wires is only a few tens of micrometres, because the pull hook or the shear tool can damage neighbouring wires thereby altering the measurement results.

Time to time, production failures (incorrect ball size, deformed ball, displaced bond, etc.) remain unnoticed until later stages of production where correction is no longer possible. This significantly increases the internal defect costs. These failures could be identified at earlier production stages with wire specific data collection and in-line data analysis. Some bonders provide data collection options, but currently, bonder data is not frequently used during production for quality control.

### Disclosure of the invention

According to aspects of the invention a method with the features of claim 1, a computer program with the features of claim 8, a data processing apparatus with the features of claim 9 as well as a computer-readable storage medium with the features of claim 10 are provided. Further features and details of the invention are disclosed in the respective dependent claims, the description and the drawings. Features and details described in the context to the inventive method also correspond to the inventive computer program, the inventive data processing apparatus as well as the inventive computer-readable storage medium, and vice versa in each case.

According to an aspect of the invention a method for predicting shear force values in a wire bonding process is provided, the method comprising the following steps, wherein the steps may be performed repeatedly and/or in a specific order. Wire bonding is particularly a method used to create electrical interconnections between a semiconductor die and its packaging, or between different components. This may involve using fine wires, for example gold, aluminium, or copper, to connect bond pads on the die to lead frames or other substrates. The invention particularly refers to Ball Bonding, where a thermosonic process is used to form a ball at the end of a wire, which is then bonded to a pad on the die. A second bond, typically a wedge bond, may then be made to a pad on the package.

In a first possible step, bonder data is provided, the bonder data comprising values for at least one process parameter that are acquired during the wire bonding process by at least one sensor, wherein the process is preferably monitored in real time. The at least one sensor may for example be a camera sensor and/or a temperature sensor and/or a pressure sensor and/or an ammeter. The at least one process parameter may comprise at least one bond process parameter, particularly an Ultrasonic Generator Current, at least one die related parameter, particularly a height, tilt and/or rotation of a die on a substrate, and/or at least one wire parameter, particularly a free air ball diameter, a bonded ball diameter and/or an estimated bonded ball height. Thus, various bonder data parameters may be considered. This comprehensive approach may lead to more accurate predictions of shear force values, ultimately enabling earlier detection of defects and reduced production costs.

In a next possible step, the shear force values in the wire bonding process are predicted based on the provided bonder data using a machine learning model. The machine learning model may be an Extreme Gradient Boosting Regressor (XGBoost Regressor), which may be particularly advantageous in the application of the invention.

It may thus advantageously be possible by using the method according to the invention to predict shear force values without destructive testing by utilizing bonder data and machine learning models. According to the invention, this may be achieved by providing bonder data comprising process parameters acquired during the wire bonding process and predicting the shear force values based on this data using a machine learning model. By training an algorithm such as XGBoost Regressor with wire-specific bonder data, including process parameters, die information, and wire geometry, it may become possible to predict wire quality and detect defects earlier in production, reducing the need for destructive testing and decreasing defect costs.

Furthermore, the predictive machine learning model may be fine-tuned and updated over time to account for changes in process parameters, die designs, or wire geometries, ensuring that the predicted shear force values remain accurate and reliable.

It is possible that the machine learning model is trained according to the following steps:
- Providing training data, the training data comprising historic values for the at least one process parameter that were acquired during at least one previous wire bonding process, the training data further comprising labels indicating corresponding shear force values for respective historic values,
- Training the machine learning model based on the provided training data to predict shear force values based on respective values for the at least one process parameter.

The training is particularly a supervised training and may also include a validation phase, where the trained machine learning model is validated. The training data may thus be split into a subset for the training phase and a subset for the validation phase.

It is possible that the training of the machine learning model further comprises the following step:
- Using a randomized search with a cross-validation to determine hyperparameters for the machine learning model.

This may have the advantage of improving the performance of the machine learning model, as hyperparameter optimization may help to find the best parameters for the machine learning model. In this way, the machine learning model may be better tuned to the specific requirements of the use case or user. It is also possible that the use of randomized search with cross-validation reduces the time and resources needed to manually search for the best hyperparameters, resulting in more efficient and cost-effective model development. Overall, this may enhance the accuracy and robustness of the predicted shear force values, thereby enabling more reliable quality control and defect detection in the wire bonding process.

It is also possible that the training further comprises the following step:
- Using an L2 regularization to decrease overfitting during training.

By incorporating an L2 regularization into the training process, the risk of overfitting may thus be mitigated. This may allow the machine learning model to generalize better and make more accurate predictions for new wires, thereby reducing the need for destructive testing and decreasing defect costs.

It is further possible that the method further comprises the following steps:
- Using the predicted shear force values to detect defects and/or errors during the wire bonding process.

The predicted shear force values may thus be used to detect defects and/or errors during the wire bonding process, allowing for earlier detection and potentially decreasing defect costs. The method according to the invention may not only reduce analysis costs but also enable a more efficient production workflow by integrating the predicted shear force values into real-time monitoring systems. This may allow for proactive measures to be taken in case of potential defects or errors, potentially reducing downtime and increasing overall product yield.

In another aspect of the invention, a computer program may be provided, in particular a computer program product, comprising instructions which, when the computer program is executed by a computer, cause the computer to carry out the method according to the invention. Thus, the computer program according to the invention can have the same advantages as have been described in detail with reference to a method according to the invention.

In another aspect of the invention, an apparatus for data processing may be provided, which is configured to execute the method according to the invention. As the apparatus, for example, a computer can be provided which executes the computer program according to the invention. The computer may include at least one processor that can be used to execute the computer program. Also, a non-volatile data memory may be provided in which the computer program may be stored and from which the computer program may be read by the processor for being carried out.

According to another aspect of the invention a computer-readable storage medium may be provided which comprises the computer program according to the invention and/or instructions which, when executed by a computer, cause the computer to carry out the steps of the method according to the invention. The storage medium may be formed as a data storage device such as a hard disk and/or a non-volatile memory and/or a memory card and/or a solid state drive. The storage medium may, for example, be integrated into the computer.

Furthermore, the method according to the invention may be implemented as a computer-implemented method. Alternatively or additionally, at least one of the disclosed method steps may be computer-implemented and/or automated.

Further advantages, features and details of the invention will be apparent from the following description, in which embodiments of the invention are described in detail with reference to the drawings. In this context, the features mentioned in the claims and in the description may each be essential to the invention individually or in any combination. Showing:

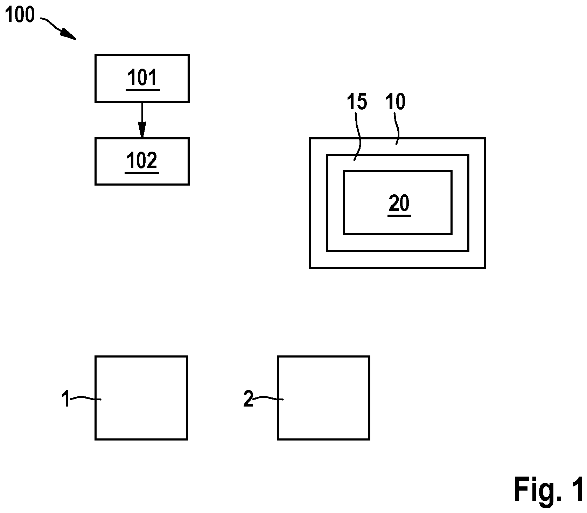

- Fig. 1:: A method, a machine learning model, a sensor, computer program, a storage medium and apparatus according to embodiments of the invention.

Fig. 1 schematically shows a method 100, a machine learning model 1, a sensor 2, a computer program 20, a storage medium 15 and an apparatus 10 according to embodiments of the invention.

Fig. 1 particularly shows an embodiment of a method 100 for predicting shear force values in a wire bonding process. In a first step 101, bonder data is provided, the bonder data comprising values for at least one process parameter that are acquired during the wire bonding process by at least one sensor 2. In a second step 102, the shear force values in the wire bonding process are predicted based on the provided bonder data using a machine learning model 1.

The method according to embodiments of the invention may minimize or eliminate the need for destructive testing by using a machine learning algorithm which is able to predict shear force values based on bonder provided data. Furthermore, with the in-line wire specific data collection, defect costs may be decreased as well due to earlier detection of failures.

When the bonding process is monitored in real time, prediction of wire quality without destructive tests by using machine learning algorithms may become possible. By machine learning, particularly supervised machine learning, using wire specific process data like geometric parameters (ball height, ball diameter) recorded by the bonder during bonding, the shear force values of every single wire may be predicted with to the method according to embodiments of the invention. Thus, the number of products analysed by destructive tests may be radically decreased which may lead to analysis cost reduction. Furthermore, the collected data may be connected to production failures and their analysis might decrease the production defect costs.

Amongst many machine learning algorithms developed for solving regression problems by means of python programming, Extreme Gradient Boosting Regressor (XGBoost) is an example that may be used for the method according to embodiments of the invention. XGBoost is particularly developed to be faster and more robust than other ensemble learning algorithms, furthermore it may handle tabular data very effectively even in case of smaller data size. Based on these facts, XGBoost may be particularly advantageous for the prediction of shear force values by supervised machine learning based on the process data of a bonder.

The bonder data used for supervised machine learning may be categorized as bond process parameters (USG current, Force), die related parameters and wire related parameters. The die related parameters are particularly the height, tilt and rotation of a die on a substrate, while the wire related parameters may comprise a free air ball diameter (FAB), a bonded ball diameter (Ball Diam), a bonded ball height (Est. Height) and a bond height delta which is a height difference between a ball and wedge sides of the bonded wire.

Shear force values may be used as target variables instead of pull force values of the wires, because shear force values may be more closely related to the bonded area than pull force values, furthermore the results may be less affected by the measurement setup, e.g. positioning of the pull hook may be rather difficult sometimes.

Providing enough data, i.e. particularly bonder data and shear force data together, to the machine learning model, particularly the XGBoost Regressor, to train on, the trained algorithm may predict shear force values (wire bond quality) solely based on bonder data recorded during bonding.

In the following, a specific use case is described as an example, where shear force prediction of 50 µm gold wire bonds is performed by an XGBoost Regressor. For supervised machine learning, pieces of a chosen transmission control units (TCUs) may be bonded using 50 µm diameter gold wires based on an experimental plan varying the process parameters. There were several wire bond connections on each TCUs. All these wires may be shear tested, which may then provide shear test data together with the corresponding bonder data that may be used for training and testing the XGBoost Regressor algorithm. During the hyperparameter tuning of the algorithm, randomized search with 5-fold cross-validation may be used to find the best hyperparameters. L2 regularization may also be used to decrease overfitting. Then the optimized algorithm may be validated on a validation set (in other words on training data that the algorithm did not see during training and testing). The validation set may also be based on TCU units.

The method according to embodiments of the invention may be used in every product where thin gold or copper wires are used and bonded by a bonder that provides monitoring the bonding process in real time, e.g. by means of transmission control units and/or camera sensors. The algorithm used in the method according to embodiments of the invention may then be trained for the other wire types and wire diameters similarly to the above example case with the with 50 µm gold wire, because the process parameters, the bonded wire geometries and the shear force values may be different for each wire type and diameter.

The above explanation of the embodiments describes the present invention in the context of examples. Of course, individual features of the embodiments can be freely combined with each other, provided that this is technically reasonable, without leaving the scope of the present invention.

## Claims

1. A method (100) for predicting shear force values in a wire bonding process, comprising the following steps:
- Providing (101) bonder data, the bonder data comprising values for at least one process parameter that are acquired during the wire bonding process by at least one sensor (2),
- Predicting (102) the shear force values in the wire bonding process based on the provided bonder data using a machine learning model (1).

2. The method (100) of claim 1, **characterized in that** the at least one process parameter comprises at least one bond process parameter, particularly an Ultrasonic Generator Current,
at least one die related parameter, particularly a height, tilt and/or rotation of a die on a substrate, and/or
at least one wire parameter, particularly a free air ball diameter, a bonded ball diameter and/or an estimated bonded ball height.

3. The method (100) of any one of the preceding claims, **characterized in that** the machine learning model (1) is trained according to the following steps:
- Providing training data, the training data comprising historic values for the at least one process parameter that were acquired during at least one previous wire bonding process, the training data further comprising labels indicating corresponding shear force values for respective historic values,
- Training the machine learning model (1) based on the provided training data to predict shear force values based on respective values for the at least one process parameter.

4. The method (100) of claim 3, **characterized in that** the training further comprises the following step:
- Using a randomized search with a cross-validation to determine hyperparameters for the machine learning model (1).

5. The method (100) of claim 3 or claim 4, **characterized in that** the training further comprises the following step:
- Using an L2 regularization to decrease overfitting during training.

6. The method (100) of any one of the preceding claims, **characterized in that** the machine learning model (1) is an Extreme Gradient Boosting Regressor.

7. The method (100) of any one of the preceding claims, **characterized in that** the method further comprises the following steps:
- Using the predicted shear force values to detect defects and/or errors during the wire bonding process.

8. A computer program (20), comprising instructions which, when the computer program (20) is executed by a computer (10), cause the computer (10) to carry out the method (100) of any one of the preceding claims.

9. A data processing apparatus (10), comprising means for carrying out the method (100) of any one of claims 1 to 7.

10. A computer-readable storage medium (15) comprising instructions which, when executed by a computer (10), cause the computer (10) to carry out the steps of the method (100) of any one of claims 1 to 7.
